# FASCICULE DE BREVET EUROPEEN

(11) **EP 1 835 373 B1**
(45) Date de publication et mention de la délivrance du brevet: **20.01.2010**
(21) Numéro de dépôt: 07104168.5
(22) Date de dépôt: 14.03.2007
(51) Int. Cl.: G05F 1/56, G05F 3/26, H03F 3/345, H03F 3/347

(54) **Génération d'une tension de référence**
Erzeugung einer Bezugsspannung
Generation of a reference voltage

(30) Priorité: 15.03.2006 FR 0650876
(43) Date de publication de la demande: 19.09.2007
(73) Titulaire: ST MICROELECTRONICS S.A., 92120 Montrouge (FR)
(72) Inventeur: Gicquel, Hugo, 38000 Grenoble (FR); Moro, Jean-Luc, 38000 Grenoble (FR); Sabut, Marc, 38320 Eybens (FR)
(74) Mandataire: de Beaumont, Michel

(56) Documents cités:
- EP-A- 1 365 302
- US-A1- 2003 011 350
- US-A1- 2003 218 450

## Description

### Domaine de l'invention

La présente invention concerne de façon générale les circuits électroniques et plus particulièrement la génération de tensions de référence proches des tensions d'alimentation du circuit.

Un exemple d'application de la présente invention concerne les convertisseurs analogique-numérique et la génération de tensions de référence définissant les niveaux des états "0" et "1" des bits. Plus généralement, l'invention s'applique dès qu'au moins une tension de référence proche du niveau d'une tension d'alimentation est souhaitée (par exemple, les convertisseurs numériques-analogiques et les circuits de référence pour signaux vidéo).

### Exposé de l'art antérieur

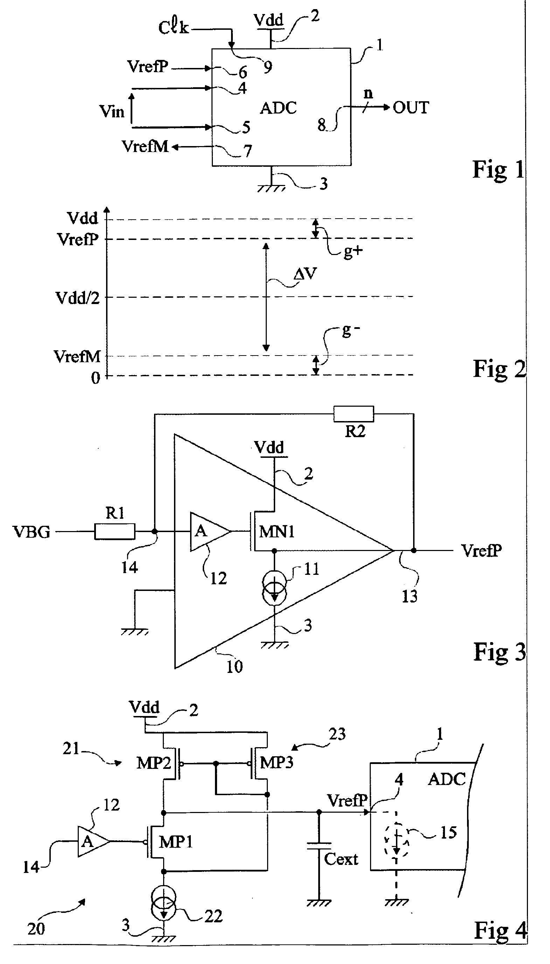

La figure 1 représente, de façon très schématique et sous forme de blocs, un exemple de convertisseur analogique-numérique 1 (ADC) du type auquel s'applique la présente invention. Un tel convertisseur est alimenté par une tension continue Vdd appliquée entre deux bornes 2 et 3 du circuit 1. Dans l'exemple de la figure 1, le convertisseur est à entrées différentielles. Un signal différentiel Vin est appliqué entre deux bornes d'entrée 4 et 5 du convertisseur qui reçoit également deux signaux de référence VrefP et VrefM sur des entrées 6 et 7. Les signaux de référence VrefP et VrefM fournissent des niveaux de tension autour de la moitié Vdd/2 de la tension d'alimentation. Une fréquence d'échantillonnage est fixée par un signal d'horloge Clk appliqué sur une entrée d'horloge 9. Le circuit 1 fournit un signal binaire OUT sur n bits sur une sortie série ou plusieurs sorties parallèles 8.

La figure 2 illustre, par une échelle de tensions, le fonctionnement du convertisseur de la figure 1. Les tensions VrefP et VrefM sont comprises entre les niveaux Vdd et 0 de part et d'autre du niveau médian Vdd/2. La différence ΔV entre les niveaux VrefP et VrefM définit la dynamique du convertisseur. Plus cet écart est important, meilleur est le rapport signal/bruit du convertisseur. L'écart g+ entre la tension Vdd et la tension VrefP et l'écart g- entre la tension VrefM et la masse (0) sont liés à des contraintes technologiques du circuit comme on le verra par la suite.

A l'intérieur du convertisseur 1, les signaux de référence VrefP et VrefM sont appliqués à un ou plusieurs éléments fonctionnant comme des sources de courant qui absorbent (sur le niveau VrefP) ou fournissent (sur le niveau VrefM) un courant dépendant de la fréquence de travail du convertisseur et du nombre d'étages fournissant respectivement des états 0 et des états 1.

Par la suite, l'invention sera décrite en relation avec la génération d'un seul niveau de référence VrefP proche du niveau positif Vdd de la tension d'alimentation. On notera toutefois qu'elle s'applique plus généralement à la génération de signaux de référence positifs ou négatifs, par exemple, dans une application différentielle. De même, pour simplifier, on se référera à une référence négative (niveau 0) correspondant à la masse sachant qu'il peut s'agir de n'importe quel niveau positif ou négatif inférieur au niveau Vdd.

La figure 3 représente, de façon schématique, un exemple classique de circuit de génération d'une tension de référence VrefP du type auquel s'applique la présente invention. Cette tension VrefP est fournie par un transistor MOS à canal N MN1, connecté entre une ligne 2 de fourniture de la tension Vdd et une source de courant 11 reliée à la masse 3. Le transistor MN1 et la source 11 forment l'étage de sortie d'un amplificateur 10 à transconductance dont une première entrée 14 reçoit, par une résistance R1, une tension de référence fixe VBG liée à la technologie (généralement appelée tension bandgap) et dont une deuxième entrée est connectée à la masse. En interne, la première entrée est reliée à un amplificateur d'entrée 12(A). La sortie 13 du circuit (drain du transistor MN1) est rebouclée sur l'entrée 14 par une résistance R2. Les valeurs respectives des résistances R1 et R2 fixent la valeur du niveau VrefP par rapport au niveau VBG.

Le montage de la figure 3 est généralement appelé "suiveur" et son rôle est de fournir le courant nécessaire au fonctionnement des circuits connectés en aval de la borne 13, tout en maintenant le niveau de tension VrefP.

Dans des applications où la tension d'alimentation Vdd est relativement faible (moins de 3V, typiquement 2,5 V), il est difficile de maintenir le niveau VrefP proche du niveau Vdd. En effet, le fonctionnement du suiveur de la figure 3 nécessite une tension d'environ 600 mV, voire 900 mV, pour fournir la tension grille-source du transistor MN1 qui impose la différence de potentiels entre la borne 2 et la borne 13. A ce problème de tension grille-source, s'ajoute la tension de déchet de l'amplificateur 12. Il en découle qu'en pratique le niveau de tension VrefP se retrouve autour du volt. En appliquant le même circuit côté génération du niveau VrefM par rapport à la masse, on voit que l'on obtient une dynamique de quelques centaines de millivolts pour le convertisseur, ce qui est en pratique insuffisant. Par conséquent, cette solution n'est pas adaptée à des tensions d'alimentation aussi faibles.

Pour rapprocher le niveau VrefP du niveau Vdd, on inverse généralement la structure de l'étage de sortie en connectant un transistor MOS à canal P en série avec une source de courant entre les bornes 2 et 3. Toutefois, cela impose de dimensionner ce transistor au pire cas de fonctionnement de l'application dans la mesure où il doit supporter l'intégralité du courant si le circuit aval (le convertisseur) n'absorbe pas de courant.

La figure 4 représente un autre exemple classique de circuit suiveur 20 de génération d'une tension de référence VrefP pour un convertisseur analogique-numérique 1. En figure 4, la source de courant 15 à laquelle est équivalent le convertisseur 1 pour la tension de référence VrefP a été illustrée en pointillés. L'entrée 4 du convertisseur 1 est reliée à la masse par un condensateur externe Cext dont le rôle est de stabiliser le niveau VrefP. Pour simplifier, seul l'étage de sortie de l'amplificateur suiveur a été représenté en figure 4. Bien entendu, un tel montage comporte également une contre-réaction (résistances R1 et R2) avec l'entrée 14 de l'amplificateur 20.

Dans l'exemple de la figure 4, un transistor MOS à canal P MP1 est commandé par l'amplificateur d'entrée 12 du montage et est relié, par une source de courant 21, à la borne d'application de la tension Vdd. Le fait de reporter la source de courant côté alimentation positive permet d'éviter la chute de tension importante liée à la tension grille-source du transistor MOS à canal N de la figure 3. Une deuxième source de courant 22 relie le drain du transistor MP1 à la masse 3 et ce drain est relié à une troisième source de courant 23 montée en miroir sur la source de courant 21. Le rapport du miroir est généralement de l'unité et la source de courant 22 est une source de courant fixe absorbant la somme des courants fournis par les sources 21 et 22. Par exemple, un premier transistor MOS à canal P MP2 constituant la source 21 relie la borne 2 à la source du transistor MP1. Sa grille est reliée directement à celle d'un deuxième transistor MP3 constitutif de la source de courant 23, les grilles communes étant par ailleurs reliées aux drains des transistors MP1 et MP3. Un tel montage permet de réduire la taille du transistor MOS MP1 dans la mesure où il n'est pas en permanence traversé par le courant maximum (pire cas) absorbé par le convertisseur aval 1.

Quand le convertisseur 1 tire du courant (source 15), l'amplificateur 12 réagit en augmentant le potentiel de la grille du transistor MP1. Cela a pour effet d'ouvrir le transistor MP1 et le transistor miroir MP2 fournit alors au convertisseur un courant correspondant à la valeur fixée par la source 21. A l'inverse, quand le convertisseur ne prélève pas de courant, le transistor MP1 est passant et le courant fixe absorbé par la source 22 n'est pas fourni uniquement par ce transistor MP1 mais également par le transistor MP3.

Par rapport au montage de la figure 3, le montage de la figure 4 permet d'atteindre une tension VrefP de l'ordre de 2 Volts pour une tension Vdd de l'ordre de 2,2 Volts (niveau Vdd diminué d'environ 0,2 V pour le fonctionnement du transistor MP2).

En reproduisant un montage similaire, (à base de transistors à canal N) côté borne négative (masse 3) de l'alimentation, on peut générer un deuxième niveau de référence VrefM à environ 0,2 V, ce qui fournit une dynamique supérieure à 1 V au convertisseur. Une telle dynamique est acceptable dans la plupart des cas.

Toutefois, un inconvénient de la solution de la figure 4 est que le courant absorbé par la source 22 reste fixé par le pire cas de fonctionnement des circuits connectés en aval et engendre donc une consommation importante. Le rendement d'un tel générateur de tension de référence reste donc faible.

Un autre inconvénient du montage de la figure 4 est le recours quasi obligatoire à un condensateur externe Cext entre le circuit suiveur 20 et le convertisseur 1. Deux condensateurs externes sont d'ailleurs nécessaires pour stabiliser les deux niveaux de référence VrefP et VrefM dans le cas d'un système différentiel.

Ce ou ces condensateurs externes ont en pratique des valeurs de plusieurs microfarads, ce qui les rend volumineux. De plus, le recours à des condensateurs externes engendre d'autres perturbations liées aux boîtiers et aux bornes de connexion.

Le brevet européen EP-A-1365302 décrit un régulateur de tension à faible déchet.

### Résumé de l'invention

La présente invention vise à pallier tout ou partie des inconvénients des générateurs de tension de référence connus ayant pour objet de générer un niveau de référence proche d'un niveau d'alimentation du circuit.

La présente invention vise plus particulièrement à proposer un générateur de niveau de référence entièrement intégrable et dépourvu de condensateur externe entre un amplificateur suiveur et une entrée d'un circuit aval exploitant la tension de référence généré.

L'invention vise également un générateur de niveau de référence dans lequel la consommation est adaptée au courant requis par les circuits connectés en aval..

L'invention vise également une solution compatible avec une utilisation en mode non différentiel et en mode différentiel.

L'invention vise également une solution particulièrement adaptée aux convertisseurs analogique-numérique et numérique-analogique leur procurant vitesse et stabilité..

Pour atteindre tout ou partie de ces objets ainsi que d'autres, la présente invention prévoit un circuit de génération d'une tension de référence par un premier transistor MOS d'un premier type de canal connecté à une première borne d'application d'une tension d'alimentation, ledit premier transistor étant en série avec un deuxième transistor MOS de même type de canal commandé par un étage d'entrée d'un amplificateur à transconductance et leur point milieu définissant une borne de sortie fournissant la tension de référence, comportant :
une première source de courant de valeur fixe reliant ladite première borne d'alimentation à une grille du premier transistor ;
une deuxième source de courant de valeur fixe reliant le deuxième transistor à une deuxième borne d'application de la tension d'alimentation ;
au moins un troisième transistor MOS d'un deuxième type de canal reliant les deux sources de courant ; et
un élément capacitif reliant directement ladite borne de sortie à une borne de conduction du troisième transistor pour faire varier la conduction de ce troisième transistor en cas de variation de la tension de sortie.

Selon un mode de réalisation de la présente invention, le troisième transistor relie directement la grille du premier transistor à la deuxième source de courant, ledit élément capacitif étant en parallèle sur le deuxième transistor.

Selon un mode de réalisation de la présente invention, un quatrième transistor du deuxième type de canal est intercalé entre le troisième transistor et la deuxième source de courant, ledit élément capacitif reliant ladite borne de sortie au point milieu entre les troisième et quatrième transistors.

Selon un mode de réalisation de la présente invention, le circuit est réalisé avec au moins deux sortes de transistors qui se différencient par leurs épaisseurs d'oxyde de grille respectives, les premier et troisième transistors étant réalisés avec un oxyde de grille relativement mince par rapport au deuxième transistor.

Selon un mode de réalisation de la présente invention, le quatrième transistor est dans un oxyde relativement épais.

Selon un mode de réalisation de la présente invention, le premier transistor est dimensionné en fonction du courant susceptible d'être appelé ou restitué par les circuits connectés à la borne de sortie.

Selon un mode de réalisation de la présente invention, le deuxième transistor est dimensionné en fonction de la valeur fixe des sources de courant.

Selon un mode de réalisation de la présente invention, la deuxième source de courant est constituée d'un transistor MOS du deuxième type polarisé par un signal fixe.

Selon un mode de réalisation de la présente invention, la première source de courant est constituée d'un transistor MOS du premier type.

Selon un mode de réalisation de la présente invention, appliqué à la génération d'une tension plus proche de celle de la première borne que de celle de la deuxième borne, les premier et deuxième types de canal sont respectivement P et N.

Selon un mode de réalisation de la présente invention, appliqué à la génération d'une tension plus proche de celle de la deuxième borne que de celle de la première borne, les premier et deuxième types de canal sont respectivement N et P.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente, de façon très schématique et sous forme de blocs, un convertisseur analogique-numérique à entrées différentielles du type auquel s'applique à titre d'exemple la présente invention ;
la figure 2 décrite précédemment représente un exemple d'échelle de tensions du convertisseur de la figure 1 ;
la figure 3 décrite précédemment représente, de façon schématique, un premier exemple classique de montage suiveur de génération d'une tension de référence ;
la figure 4 décrite précédemment représente un deuxième exemple classique de montage suiveur de génération d'une tension de référence ;
la figure 5 représente un premier mode de réalisation d'un circuit de génération d'une tension de référence selon la présente invention ;
la figure 6 représente un deuxième mode de réalisation d'un circuit de génération de référence selon la présente invention ; et
la figure 7 est un schéma électrique partiellement détaillé du circuit de la figure 5.

De mêmes éléments ont été désignés par de mêmes références aux différentes figures. Pour des raisons de clarté seuls les éléments qui sont utiles à la compréhension de l'invention ont été représentés et seront décrits par la suite. En particulier, les détails constitutifs d'un circuit (par exemple, un convertisseur analogique-numérique) utilisant des tensions de référence générées par un montage de l'invention n'ont pas été exposés, l'invention n'engendrant aucune modification des circuits connectés en aval du circuit de génération de la tension de référence.

### Description détaillée

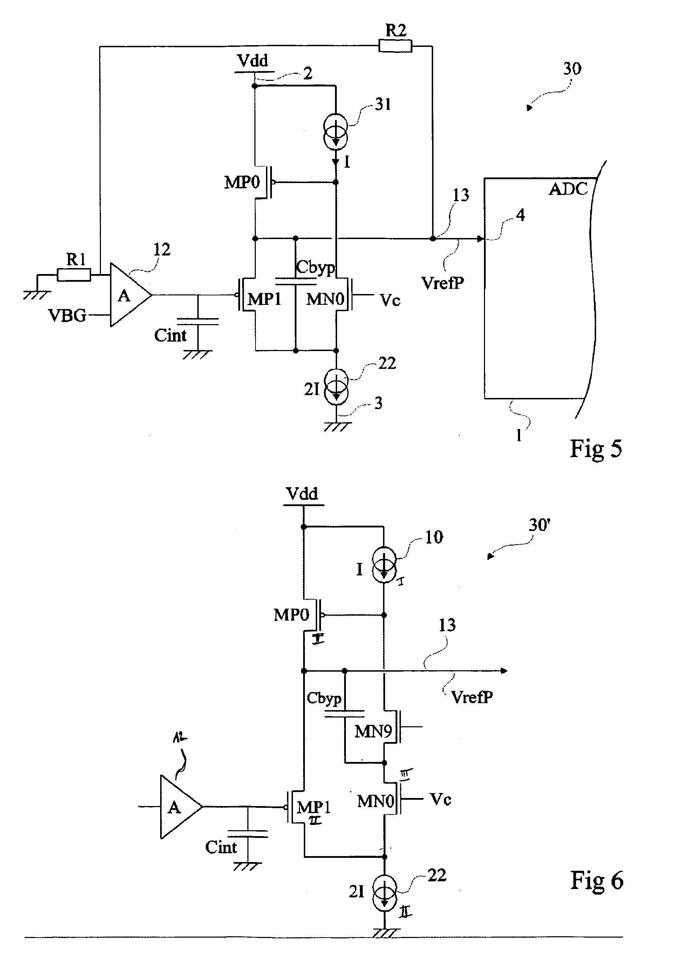

La figure 5 représente, partiellement et de façon schématique, un premier mode de réalisation d'un circuit 30 constituant un montage suiveur de génération d'une tension positive VrefP selon l'invention. Cette tension est, par exemple, destinée à un circuit 1 de conversion analogique-numérique ADC dont une borne d'entrée 4 reçoit le niveau VrefP.

Comme dans la solution précédente de la figure 4, un amplificateur d'entrée 12 (A) recevant un niveau de référence (par exemple, une tension de type bandgap VBG) commande un transistor MOS à canal P MP1 dont la source fournit la tension VrefP sur une borne de sortie 13. Dans l'exemple de la figure 5, l'amplificateur 12 est un amplificateur différentiel recevant sur une première entrée le niveau VBG et sur une deuxième entrée une information représentative de la tension VrefP par l'intermédiaire d'un pont diviseur résistif (résistances R2 et R1 en série entre la borne 13 et la masse). Cela constitue une alternative au montage d'entrée de la figure 3 mais ne change pas le principe de fonctionnement. Un condensateur Cint relie la grille du transistor MP1 à la masse pour stabiliser le montage. La valeur de ce condensateur (de l'ordre du picofarad) est négligeable par rapport aux valeurs des condensateurs externes classiques.

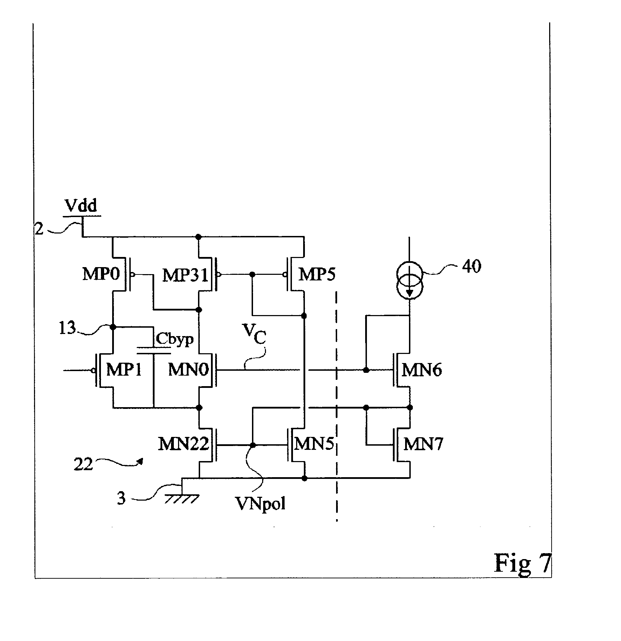

La source du transistor MP1 est reliée à une borne 2 d'application d'une tension Vdd d'alimentation par un transistor MOS à canal P MP0 dont la grille est reliée à la borne 2 par une source de courant 31. A la différence du montage de la figure 4, la source de courant 31 fournit un courant I fixe, le transistor constitutif de cette source de courant n'est donc pas monté en miroir sur le transistor MP0. Une deuxième source 22 de courant fixe relie le drain du transistor MP1 à la masse 3 et un transistor MOS à canal N MN0 relie la grille du transistor MP0 (sortie de la source 31) au drain du transistor MP1. Le rôle du transistor MN0 est de fixer la tension de drain du transistor MP1 par rapport à la masse 3, ce qui revient à rendre ce niveau de drain indépendant de la tension de grille du transistor MP0 pour permettre le fonctionnement du transistor MP1. La source 31 de valeur fixe est, de préférence, un miroir de courant de la source 22. Le transistor MN0 est commandé par un signal de tension fixe Vc dont la génération sera décrite par la suite en relation avec la figure 7. Cette tension Vc est une tension constante dans la mesure où le transistor MN0 est toujours passant. La tension Vc est choisie pour être supérieure à la tension drain-source de saturation du transistor constitutif de la source 22, majorée de la chute de tension Vgs grille-source du transistor MN0.

Une caractéristique de ce premier mode de réalisation est de prévoir un élément capacitif Cbyp entre la borne 13 et la borne du transistor MN0 pour transférer rapidement une variation de potentiel sur la borne 13 liée à une variation du prélèvement de courant par le circuit aval 1 sur la source du transistor MN0. Par exemple, en cas d'augmentation de cet appel de courant, le potentiel de la borne 13 commence à chuter. Cette diminution est transmise par le condensateur Cbyp sur la source du transistor MN0. Comme le potentiel de grille de ce transistor MN0 est fixe, la diminution du potentiel de la borne 13 se traduit par une augmentation de la tension grille-source Vgs du transistor MN0. Le courant qui le traverse augmente, d'où une baisse de potentiel de la grille du transistor MP0 (la source 31 fournissant un courant fixe). En augmentant ainsi la tension grille-source du transistor MP0, celui-ci peut fournir un courant plus important et répondre ainsi rapidement à l'appel de courant supplémentaire de la charge. Si cette augmentation de courant appelé par la charge dure, l'amplificateur 12 provoque une diminution de la tension de grille du transistor MP1, ce qui augmente le courant dans ce transistor pour atteindre la valeur I et retrouver une situation d'équilibre avec celui circulant dans le transistor MN0.

Le circuit 30 de la figure 5 comporte donc fonctionnellement un élément de réaction relativement rapide constitué par la capacité Cbyp pour transférer une variation du potentiel de la borne 13 sur la source du transistor MN0, et une boucle de réaction plus lente par les résistances R1 et R2.

La figure 6 représente un montage suiveur 30' selon un deuxième mode de réalisation de la présente invention. Pour simplifier, la boucle de réaction constituée des résistances R1 et R2 de la figure 5, bien que présente en figure 6, n'a pas été représentée de même que la charge (le convertisseur).

Par rapport au montage de la figure 5, une première différence est l'ajout d'un transistor MOS à canal N MN9 entre la source de courant 31 et le transistor MN0. Une deuxième différence est la connexion de l'élément capacitif Cbyp entre la borne 13 et le point milieu entre le transistor MN9 et le transistor MN0. La grille du transistor MN9 reçoit un signal de polarisation dont un exemple sera exposé ultérieurement en relation avec la figure 7.

Dans ce mode de réalisation, la tension grille-source du transistor MN0 reste fixe et l'élément capacitif Cbyp intervient sur la conduction du transistor MN9. Une modification de la tension VrefP en sortie du montage se traduit immédiatement par une modification du potentiel de drain du transistor MN0 (source du transistor MN9). L'augmentation ou la diminution de courant qui en résulte dans le transistor MN9 engendre une baisse ou une augmentation du potentiel de grille du transistor MP0 qui fournit alors plus ou moins de courant à la charge. Comme dans le premier mode de réalisation, si le phénomène dure, la contre-réaction sur l'amplificateur d'entrée (représenté ici de façon simplifiée comme en figure 4) modifie la tension grille-source du transistor MP1 pour rééquilibrer son courant avec celui du transistor MN0.

L'ordre de grandeur de l'élément capacitif Cbyp utilisé dans la présente invention est le picofarad, ce qui rend cet élément intégrable. En effet, l'élément capacitif Cbyp ne sert pas, contrairement à l'élément capacitif (Cext, figure 4) de sortie du montage classique, de réservoir de stockage pour fournir les appels de la charge, mais d'élément de stabilisation de la boucle formée par les transistors MP0, MP1 et MN0. L'élément Cext peut donc être plus petit.

Les valeurs des sources de courant 31 et 22 sont choisies pour être les plus faibles possible, sachant que plus le courant est important, plus le système est rapide à charger et décharger la capacité de grille du transistor MP0. Comme ce transistor MP0 est dimensionné en fonction du pire cas pour l'application pour être capable de véhiculer le courant appelé par les circuits connectés en aval, sa capacité de grille conditionne les tailles des sources de courant 31 et 22.

Un avantage du deuxième mode de réalisation par rapport au premier est qu'il réduit les effets d'une capacité parasite présente entre la source du transistor MN0 et la masse qui se retrouve, dans le montage de la figure 5, en série avec l'élément capacitif Cbyp et qui est due aux transistors MP0, MN0 et au transistor constitutif de la source 22.

Un avantage de la présente invention est que le circuit de génération de tension de référence est rapide et stable sans qu'il soit nécessaire de recourir à des éléments capacitifs externes ni à augmenter les courants dans les sources de courant 31 et 22. En effet, on aurait pu penser augmenter la rapidité du montage en augmentant les courants I et 2I des sources de courant 31 et 22. Mais cela accroît la consommation du montage et cela ne résout pas les problèmes de stabilité.

La figure 7 représente un schéma électrique partiel et détaillé illustrant un mode de réalisation des sources de courant 31 et 22 ainsi que la génération du signal Vc selon l'invention.

La source de courant 22 comporte un transistor MOS à canal N MN22 reliant le drain du transistor MP1 à la masse 3. La grille du transistor MN22 reçoit un signal VNpol de polarisation. Ce signal correspond au signal de polarisation habituellement généré pour polariser l'ensemble des transistors à canal N du circuit et se retrouve dans tous les systèmes classiques.

La source de courant 31 est constituée d'un transistor MOS à canal P MP31 reliant la borne 2 à la grille du transistor MP0. Pour fixer le rapport entre le courant I de la source 31 et celui de la source 22 de façon fixe, le transistor MP31 est monté en miroir de courant sur un transistor MOS à canal P MP5, lui-même en série avec un transistor MOS à canal N MN5 entre les bornes 2 et 3. Le transistor MN5 a sa grille reliée à celle du transistor MN22 tandis que le transistor MP5 a sa grille reliée à son drain et à la grille du transistor MP31. Le rapport (par exemple, 2) entre les courants des sources 22 et 31 est fixé par le rapport de surfaces entre les transistors MP5 et MP31. En supposant que les transistors MN5 et MN22 ont tous deux la même taille, un transistor MP5 de taille double par rapport à celui du transistor MP31 fixe un rapport 2 entre les sources 22 et 31.

Les signaux Vc et VNpol sont fournis, par exemple, par deux transistors à canal N MN6 et MN7 montés en diode et connectés en série et entre une source de courant 40 et la masse, la source 40 fournissant un courant constant ou compensé en température. Les grilles des transistors MN6 et MN7 sont reliées aux grilles respectives des transistors MN0 et MN22.

Dans le cas du montage de la figure 6 (variante représentée en pointillés en figure 7), le transistor MN9 est polarisé par un transistor MOS à canal N MN8, monté en diode entre la source de courant 40 et le transistor MN6. Le drain du transistor MN8 est relié à sa grille et à la grille du transistor MN9 et sa source est reliée au drain du transistor MN6.

Dans une technologie où on dispose de transistors relativement rapides (oxyde de grille relativement mince - simple oxyde) et d'autres relativement lents (oxyde de grille relativement épais - double oxyde) mais tenant mieux la tension, on choisit les différents transistors du montage en fonction de leurs besoins respectifs en termes de rapidité et de tension qu'ils doivent supporter.

En prenant cet exemple, dans le mode de réalisation de la figure 5, les transistors MP0 et MP31 sont choisis relativement rapides afin de modifier rapidement le potentiel de grille du transistor MP0. Le transistor MP1 n'a pas besoin d'être rapide car il fait partie de la boucle de régulation lente. Il a toutefois besoin de supporter la tension.

Dans le premier mode de réalisation (figure 5), le transistor MN0 est dans la boucle de réaction rapide et est donc choisit relativement rapide.

Dans le deuxième mode de réalisation (figure 6), le transistor MN0 peut être un transistor lent alors que le transistor MN9 est choisi rapide.

Dans une réalisation pratique de l'invention, des transistors non représentés sont de préférence insérés dans le circuit pour protéger alors les transistors rapides contre des surtensions à leurs bornes lorsque le circuit n'est pas en fonctionnement. Ces transistors de protection sont choisis pour supporter la tension (ils sont donc lents) et ont pour objectif de porter toutes les bornes des transistors rapides à un même potentiel (généralement, Vdd).

Dans le premier mode de réalisation (figure 5), cela revient à tirer au potentiel Vdd les grilles des transistors MP0, MP31 et MP5, le drain du transistor MP0 (nécessitant l'insertion d'un transistor additionnel pour ouvrir le circuit entre les transistors MP0 et MP1 lors de l'extinction) et la source du transistor MN0.

Dans le deuxième mode de réalisation (figure 6), la seule modification est de tirer au potentiel Vdd le point milieu entre les transistors MN9 et MN0 au lieu de la source du transistor MN0.

La présente invention apporte d'autres avantages que la suppression d'une capacité externe et la possibilité d'intégrer tout le circuit, parmi lesquels :
le besoin d'un seul transistor (MP0) dimensionné pour supporter tout le courant de l'application ;
une réduction de la consommation au repos du système en rendant le courant absorbé par le circuit aval indépendant des courants consommés par la structure de commande ; et
une compatibilité du montage avec la génération de tensions de référence proches des niveaux d'alimentation.

Bien entendu, la présente invention est susceptible de diverses variantes et modifications qui apparaîtront à l'homme de l'art. En particulier, la transposition du circuit décrit à la génération d'une tension de référence par rapport à la masse à partir d'un montage dual en remplaçant les transistors à canal N par des transistors à canal P et inversement est à la portée de l'homme du métier à partir des indications fonctionnelles données ci-dessus. De plus, les dimensions respectives à donner aux différents transistors en fonction de l'application sont également à la portée de l'homme de l'art.

## Revendications

1. Circuit de génération, à partir d'un niveau de référence fixe (VBG), d'une tension de référence (VrefP) par un premier transistor MOS (MP0) d'un premier type de canal connecté à une première borne (2) d'application d'une tension d'alimentation (Vdd), ledit premier transistor étant en série avec un deuxième transistor MOS (MP1) de même type de canal commandé par un étage d'entrée (12) d'un amplificateur à transconductance et leur point milieu définissant une borne (13) de sortie fournissant la tension de référence, l'amplificateur à transconductance recevant, en entrée, ledit niveau de référence fixe et un signal représentatif de la tension de référence générée, le circuit de génération comportant
une première source de courant (31) de valeur fixe reliant. ladite première borne d'alimentation à une grille du premier transistor ; le circuit de génération etant **caractérisé par** :
une deuxième source de courant (22) dé valeur fixe reliant le deuxième transistor à une deuxième borne (3) d'application de la tension d'alimentation ;
au moins un troisième transistor MOS (MNO, MN9) d'un deuxième type de canal reliant les deux sources de courant (31, 22) ; et
un élément capacitif (Cbyp) reliant directement ladite borne de sortie à une borne de conduction du troisième transistor pour faire varier la conduction de ce troisième transistor en cas de variation de la tension de sortie.

2. Circuit selon la revendication 1, dans lequel le troisième transistor (MN0) relie directement la grille du premier transistor (MP0) à la deuxième source de courant (22), ledit élément capacitif (Cbyp) étant en parallèle sur le deuxième transistor (MP1)

3. Circuit selon la revendication 1, dans lequel un quatrième transistor (MN0) du deuxième type de canal est intercalé entre le troisième transistor (MN9) et la deuxième source de courant (22), ledit élément capacitif (Cbyp) reliant ladite borne de sortie (13) au point milieu entre les troisième et quatrième transistors..

4. Circuit selon l'une quelconque des revendications 1 à 3, réalisé avec au moins deux sortes de transistors qui se différencient par leurs épaisseurs d'oxyde de grille respectives, les premier et troisième transistors (MP0 ; MNO, MN9) étant réalisés avec un oxyde de grille relativement mince par rapport au deuxième transistor (MP1).

5. Circuit selon la revendication 4, dans son rattachement à la revendication 3, dans lequel le quatrième transistor (MN0) est dans un oxyde relativement épais.

6. Circuit selon l'une quelconque des revendications 1 à 5, dans lequel le premier transistor (MP0) est dimensionné en fonction du courant susceptible d'être appelé ou restitué par les circuits connectés à la borne de sortie (13).

7. Circuit selon l'une quelconque des revendications 1 à 6, dans lequel le deuxième transistor (MP1) est dimensionné en fonction de la valeur fixe des sources de courant (31, 22)

8. Circuit selon l'une quelconque des revendications 1 à 7, dans lequel la deuxième source de courant (22) est constituée d'un transistor MOS (MN22) du deuxième type polarisé par un signal fixe (VNpol)..

9. Circuit selon la revendication 8, dans lequel la première sources de courant (31) est constituée d'un transistor MOS (MP31) du premier type.

10. Circuit selon l'une quelconque des revendications 1 à 9, de génération d'une tension (VrefP) plus proche de celle de la première borne que de celle de la deuxième borne, dans lequel les premier et deuxième types de canal sont respectivement P et N..

11. Circuit selon l'une quelconque des revendications 1 à 9, de génération d'une tension (VrefN) plus proche de celle de la deuxième borne que de celle de la première borne, dans lequel les premier et deuxième types de canal sont respectivement N et P.

## Claims

1. A circuit of generation, from a fixed reference level (VBG), of a reference voltage (VrefP) by a first MOS transistor (MP0 of a first channel type connected to a first terminal (2) of application of a supply voltage (Vdd), said first transistor being in series with a second MOS transistor (MP1) of the same channel type controlled by an input stage (12) of a transconductance amplifier, a junction point of the first and second transistors defining an output terminal (13) providing the reference voltage, the transconductance amplifier receiving said fixed reference level and a signal representative of the generated reference voltage, the generation circuit comprising:
a first current source (31) of fixed value connecting said first supply terminal to a gate of the first transistor;
the generation circuit being **characterized in that**:
a second current source (22) of fixed value connecting the second transistor to a second terminal (3) of application of the supply voltage;
at least one third MOS transistor (MN0, MN9) of a second channel type connecting the first and second current sources (31, 22); and
a capacitive element (Cbyp) directly connecting said output terminal to a conduction terminal of the third transistor to vary the conduction of this third transistor in case of a variation in the output voltage.

2. The circuit of claim 1, wherein the third transistor (MN0) directly connects the gate of the first transistor (MP0 to the second current source (22), said capacitive element (Cbyp) being in parallel on the second transistor (MP1).

3. The circuit of claim 1, wherein a fourth transistor (MN0) of the second channel type is interposed between the third transistor (MN9) and the second current source (22), said capacitive element (Cbyp) connecting said output terminal (13) to the junction point of the third and fourth transistors.

4. The circuit of any of claims 1 to 3, wherein the circuit is formed with at least two types of transistors which differentiate by their respective gate oxide thicknesses, the first and third transistors (MP0 MN0, MN9) being formed with a relatively thin gate oxide with respect to the second transistor (MP1) .

5. The circuit of claims 3 and 4, wherein the fourth transistor (MN0) comprises a relatively thick gate oxide.

6. The circuit of any of claims 1 to 5, wherein the first transistor (MP0 is sized according to the current likely to be drawn or given back by the circuits connected to the output terminal (13).

7. The circuit of any of claims 1 to 6, wherein the second transistor (MP1) is sized according to the fixed value of the current sources (31, 22).

8. The circuit of any of claims 1 to 7, wherein the second current source (22) is formed of a MOS transistor (MN22) of the second type biased by a fixed signal (VNpol).

9. The circuit of claim 8, wherein the first current source (31) comprises a MOS transistor (MP31) of the first type.

10. The circuit of any of claims 1 to 9, for generating a voltage (VrefP) closer to that of the first terminal than to that of the second terminal, wherein the first and second channel types are respectively P and N.

11. The circuit of any of claims 1 to 9, for generating a voltage (VrefN) closer to that of the second terminal than to that of the first terminal, wherein the first and second channel types are respectively N and P.

## Patentansprüche

1. Eine Schaltung zur Erzeugung, aus einem festen Referenzpegel (VBG), einer Referenzspannung (VrefP) durch einen ersten MOS Transistor (MP0) eines ersten Kanaltyps, verbunden mit einem ersten Anschluss bzw. Terminal (2) zum Anlegen einer Versorgungsspannung (Vdd), wobei der erste Transistor in Reihe geschaltet ist mit einem zweiten MOS Transistor (MP1) desselben Kanaltyps, gesteuert durch eine Eingangsstufe (12) eines Transkonduktanzverstärkers, wobei ein Verbindungspunkt der ersten und zweiten Transistoren einen Ausgangsanschluss bzw. -terminal (13) definiert, der die Referenzspannung vorsieht, wobei der Transkonduktanzverstärker den festen Referenzpegel und ein Signal das für die erzeugte Referenzspannung repräsentativ ist empfängt, wobei die Erzeugungsschaltung aufweist:
eine erste Stromquelle (31) mit festem Wert, die den ersten Versorgungsanschluss mit einem Gatter von dem ersten Transistor verbindet;
wobei die Erzeugungsschaltung **dadurch gekennzeichnet ist, dass**:
eine zweite Stromquelle (22) mit festem Wert den zweiten Transistor mit einem zweiten Anschluss (3) zum Anlegen der Versorgungsspannung verbindet;
wenigstens ein dritter MOS Transistor (MNO, MN9) mit einem zweiten Kanaltyp die ersten und zweiten Stromquellen (31, 22) verbindet; und ein kapazitives Element (Cbyp) den Ausgangsanschluss mit einem Leitanschluss von dem dritten Transistor verbindet zum Variieren der Leitung bzw. des Leitvermögens von diesem dritten Transistor im Falle einer Variation in der Ausgangsspannung.

2. Schaltung nach Anspruch 1, wobei der dritte Transistor (MN0) das Gatter von dem ersten Transistor (MP0) mit der zweiten Stromquelle (22) direkt verbindet, wobei das kapazitive Element (Cbyp) parallel zu dem zweiten Transistor (MP1) geschaltet ist.

3. Schaltung nach Anspruch 1, wobei ein vierter Transistor (MN0) von dem zweiten Kanaltyp eingefügt ist zwischen dem dritten Transistor (MN9) und der zweiten Stromquelle (22), wobei das kapazitive Element (Cbyp) den Ausgangsanschluss (13) mit dem Verbindungspunkt von den dritten und vierten Transistoren verbindet.

4. Schaltung nach irgendeinem der Ansprüche 1 bis 3, wobei die Schaltung mit wenigstens zwei Typen von Transistoren gebildet ist, die sich durch ihre entsprechenden Gatter-Oxyd-Dicken unterscheiden, wobei die ersten und dritten Transistoren (MP0 MNO, MN9) mit einem relativ dünnen Gatter-Oxyd bezogen auf den zweiten Transistor (MP1), gebildet werden.

5. Schaltung nach den Ansprüchen 3 und 4, wobei der vierte Transistor (MN0) ein relativ dickes Gatter-Oxyd aufweist.

6. Schaltung nach irgendeinem der Ansprüche 1 bis 5, wobei der erste Transistor (MP0) bezüglich der Größe ausgelegt ist gemäß dem Strom, der durch die mit dem Ausgangsanschluss (13) verbundenen Schaltungen wahrscheinlich gezogen oder zurückgeführt wird.

7. Schaltung nach irgendeinem der Ansprüche 1 bis 6, wobei der zweite Transistor (MP1) bezüglich der Größe ausgelegt ist gemäß dem festen Wert von den Stromquellen (31, 22).

8. Schaltung nach irgendeinem der Ansprüche 1 bis 7, wobei die zweite Stromquelle (22) gebildet ist aus einem MOS Transistor (MN22) des zweiten Typs und zwar biased bzw. vorgespannt durch ein festes Signal (VNpol).

9. Schaltung nach Anspruch 8, wobei die erste Stromquelle (31) einen MOS Transistor (MP31) des ersten Typs aufweist.

10. Schaltung nach irgendeinem der Ansprüche 1 bis 9, zum Erzeugen einer Spannung (VrefP), die jener von dem ersten Anschluss näher ist als jener von dem zweiten Anschluss, wobei die ersten und zweiten Kanaltypen entsprechend P and N sind.

11. Schaltung nach irgendeinem der Ansprüche 1 bis 9, zum Erzeugen einer Spannung (VrefN), die jener von dem zweiten Anschluss näher ist als jener von dem ersten Anschluss, wobei die ersten und zweiten Kanaltypen entsprechend N und P sind.
